(19) Europäisches Patentamt / European Patent Office / Office européen des brevets

(11) **EP 2 976 651 B1**

(12) **EUROPÄISCHE PATENTSCHRIFT**

(45) Veröffentlichungstag und Bekanntmachung des Hinweises auf die Patenterteilung:
**28.10.2020 Patentblatt 2020/44**

(21) Anmeldenummer: **14712646.0**

(22) Anmeldetag: **21.03.2014**

(51) Int Cl.:
*G01R 31/26* *(2020.01)*        *G01N 21/66* *(2006.01)*
*H01L 21/66* *(2006.01)*

(86) Internationale Anmeldenummer:
**PCT/EP2014/055728**

(87) Internationale Veröffentlichungsnummer:
**WO 2014/147234 (25.09.2014 Gazette 2014/39)**

(54) **VORRICHTUNG ZUR BESTIMMUNG DER LADUNGSTRÄGERLEBENSDAUER EINES HALBLEITERSUBSTRATES DURCH MESSUNG VON LUMINESZENZSTRAHLUNG UND KALIBRIERVERFAHREN ZUR KALIBRIERUNG EINER SOLCHEN VORRICHTUNG**

DEVICE FOR DETERMINING THE CHARGE CARRIER LIFETIME OF A SEMICONDUCTOR SUBSTRATE BY MEASURING LUMINESCENT RADIATION AND CALIBRATION METHOD FOR CALIBRATING SUCH A DEVICE

DISPOSITIF POUR DÉTERMINER LA DURÉE DE VIE DU PORTEUR DE CHARGE D'UN SUBSTRAT SEMI-CONDUCTEUR EN MESURANT LE RAYONNEMENT LUMINESCENT ET PROCÉDÉ D'ÉTALONNAGE POUR ÉTALONNER UN TEL DISPOSITIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.03.2013 DE 102013205042**

(43) Veröffentlichungstag der Anmeldung:
**27.01.2016 Patentblatt 2016/04**

(73) Patentinhaber: **Fraunhofer-Gesellschaft zur Förderung der angewandten Forschung e.V.
80686 München (DE)**

(72) Erfinder:
• **GIESECKE, Johannes**
**79100 Freiburg (DE)**
• **WARTA, Wilhelm**
**79110 Freiburg (DE)**
• **SCHUBERT, Martin**
**79238 Ehrenkirchen (DE)**

(74) Vertreter: **Lemcke, Brommer & Partner Patentanwälte Partnerschaft mbB Siegfried-Kühn-Straße 4 76135 Karlsruhe (DE)**

(56) Entgegenhaltungen:
EP-A2- 2 421 052        EP-A2- 2 568 275
WO-A1-2010/022962        WO-A1-2011/134602
CN-A- 102 608 510        RU-C1- 2 018 993
US-A1- 2009 127 448

• WANG J ET AL: "TRANSIENT ELECTROLUMINESCENCE BEHAVIOR AND MECHANISM OF A SCHOTTKY-TYPE POROUS SILICON DIODE", JOURNAL OF APPLIED PHYSICS, AMERICAN INSTITUTE OF PHYSICS, US, Bd. 75, Nr. 2, 15. Januar 1994 (1994-01-15), Seiten 1070-1073, XP000425462, ISSN: 0021-8979, DOI: 10.1063/1.356488
• FUYUKI TAKASHI ET AL: "Photographic surveying of minority carrier diffusion length in polycrystalline silicon solar cells by electroluminescence", APPLIED PHYSICS LETTERS, A I P PUBLISHING LLC, US, vol. 86, no. 26, 24 June 2005 (2005-06-24), pages 262108-262108, XP012066015, ISSN: 0003-6951, DOI: 10.1063/1.1978979

**Beschreibung**

Die Erfindung betrifft eine Vorrichtung zur Bestimmung von Materialparametern gemäß Anspruch 1 sowie ein Verfahren zur Kalibrierung einer solchen Vorrichtung gemäß Anspruch 2.

Bei Halbleitersubstraten, insbesondere bei dotierten Halbleitersubstraten, ist es bekannt, anhand einer in dem Halbleitersubstrat erzeugten Lumineszenzstrahlung und deren Messung Aufschluss über Materialparameter des Halbleitersubstrates zu erlangen. Dies wird insbesondere bei Siliziumwafern angewendet. Typischerweise werden Messungen der Lumineszenzstrahlung dazu verwendet, Kenntnis über die Materialqualität hinsichtlich der effektiven Lebensdauer der Minoritätsladungsträger bei dotierten Halbleitersubstraten oder der hierzu korrespondierenden effektiven Diffusionslänge zu erlangen.

Hierbei ist es bekannt, die Diffusionslänge/Lebensdauer des Halbleitermaterials aus der Messung der Lumineszenzstrahlung zu bestimmen. Entsprechende Vorgehensweisen sind in der Literatur beschrieben, beispielsweise in Fuyuki, T. et al, "Photographic surveying of minority carrier diffusion length in polycrystalline silicon solar cells by electroluminescence", Applied Physics Letters 86: 262108, 2005, oder in Würfel, P. et al, "Diffusions lengths of silicon solar cells from luminescence images", Journal of Applied Physics, 101: 123110, 2007, oder in Trupke, T. et al, "Photoluminescence imaging of silicon wafers", Applied Physics Letters, 89: 044107, 2006.

Weiterhin sind Messmethoden bekannt, bei denen die Beaufschlagung des Halbleitersubstrates mit modulierter Anregungsstrahlung erfolgt, so dass die durch die Anregungsstrahlung bedingte Generationsrate G von Ladungsträgerpaaren in dem Halbleitersubstrat zeitlich variabel ist und mindestens ein Maximum aufweist. Typischerweise wird eine periodische, sinusartige Modulation verwendet. Hierbei erfolgt die Modulation derart, dass ein quasi statischer Zustand erreicht wird. Die entsprechende Messmethode mit Auswertung der Photolumineszenzstrahlung ist als quasi statische Photolumineszenz-Lebensdauermessung (quasi-steady-state photoluminescence life time measurements, QSS-PL) bekannt und beispielsweise in T. Trupke and R. A. Bardos, 31 st IEEE PVSC, Orlando, 2005 beschrieben.

Bei den quasi statischen Photolumineszenz-Messmethoden ist die quantitative Ermittlung der Überschussladungsträgerdichte $\Delta n$ zur Bestimmung beispielsweise der effektiven Lebensdauer $\tau$ der Minoritätsladungsträger wesentlich. Zur Kalibrierung der quasi-statischen Photolumineszenz-Messmethoden ist es bekannt, mittels einer Selbstkonsistenz-Methode entsprechende Kalibrierparameter zu ermitteln, wie beispielsweise in T. Trupke, R.A. Bardos, M.D. Abbott, "Self-Consistent Calibration of Photoluminescence and Photoconductance Lifetime Measurements", Applied Physics Letters, 87: 184102, 2005 beschrieben. Eine alternative Methode, die auf ähnlicher physikalischer Grundlage basiert, jedoch unabhängig von a priori Annahmen über die Substratdotierung ist, ist in WO 2011/134602 offenbart sowie in J.A. Giesecke, M.C. Schubert, W. Warta, "Self-sufficient minority carrier lifetime in silicon from quasi-steady-state photoluminescence" Phys. Stat. Sol. A 209: 2286, 2012 erweitert/verallgemeinert.

CN 102608510 offenbart eine Vorrichtung und ein Verfahren, bei denen die Ladungsträgerlebensdauer einer zu messenden Solarzelle unter Verwendung einer charakteristischen Beziehung zwischen Landuingsträgerlebensdauer und Intensität von Elektrolumineszenzstrahlung der Solarzelle erhalten wird.

EP 2 568 275 A2 offenbart eine Vorrichtung zur Analyse einer Elektrolumineszenz-Probe (EL-Probe) wie z.B. einer Solarzelle, wobei Information bezüglich der Lebensdauer einer EL-Emissionsvorrichtung analysiert wird. Die Vorrichtung umfasst einen Impulsgenerator, ein Mikroskop, einen optischen Separator, einen EL-Detektor, einen Verstärker, einen A/D-Wandler, eine Steuereinheit und eine Analyseeinheit.

Dynamische und insbesondere zeitmodulierte Methoden zur Bestimmung der Ladungsträgerlebensdauer in Silicium weisen einige Vorteile gegenüber statischen Bestimmungsmethoden auf. Wesentliche Vorteile liegen in der Redundanz nahezu sämtlicher a priori Annahmen über elektrische Transporteigenschaften (Dotierung, Beweglichkeiten) der untersuchten Materialien.

Der folgenden Erfindung liegt die Aufgabe zugrunde, ein verbessertes und/oder kostengünstigeres Verfahren sowie eine solche Vorrichtung zur Bestimmung der Ladungsträgerlebensdauer eines Halbleitersubstrates durch Messung von Lumineszenzstrahlung zur Verfügung zustellen.

Die Erfindung ist in der Erkenntnis des Anmelders begründet, dass die vorbekannten Verfahren, welche die Photolumineszenzstrahlung in dem Halbleitersubstrat mittels Beaufschlagen des Halbleitersubstrates mit Strahlung (so genannte Verfahren mittels Messung der "Photolumineszenz") mehrere Nachteile aufweisen:

a) Flexibilität der Messgeometrie: Bei optischer Anregung freier Ladungsträger und gleichzeitiger optischer Messung der strahlenden Rekombination muss gewährleistet sein, dass die ungewollte Detektion des Anregungslichts stets vernachlässigbar gegenüber der Lumineszenz-Detektion ist. Dies setzt optische Filterung voraus, die zusätzliche Filterartefakte verursacht, die die Flexibilität der Positionierung des Detektors erheblich einschränkt, und die in aller Regel eine deutliche Erniedrigung des Mess-Raumwinkels zur Folge hat.

b) Problematik gleichzeitiger Lumineszenz-Detektion und Anregung auf einer Substratseite: Da vollflächig metallisierte Substrate nur einseitig optisch zugänglich sind muss im Fall optischer Ladungsträgergeneration Anregung und Lumineszenz-Detektion von ebendieser zugänglichen Seite erfolgen. Damit ist es praktisch unmöglich, ein Substrat vollflächig zu beleuchten und gleichzeitig dessen Lumineszenz in einem definierten und lokal eingegrenzten Bereich zu messen. Genau dies ist aber Voraussetzung für einige wichtige Anwendungen wie z.B. die ortsaufgelöste Lebensdauerbestimmung von PL-Images anhand einer dynamischen PL-Messung.

c) Kosten der Vorrichtung: Zur Messung der Photolumineszenz wird typischerweise das Halbleitersubstrat mit elektromagnetischer Strahlung beaufschlagt, welche mittels eines Hochleistungslasers erzeugt wird. Dessen Anschaffungskosten liegen deutlich über denen einer etwa zur elektrischen Injektion freier Ladungsträger benötigten Strom-Spannungsquelle.

Diese Nachteile werden mit einer erfindungsgemäßen Vorrichtung gemäß Anspruch 1 und Kalibrieren einer solchen Vorrichtung mittels eines Verfahrens gemäß Anspruch 2 vermieden. Vorzugsweise Ausgestaltungen des erfindungsgemäßen Verfahrens finden sich in den Ansprüchen 3 bis 6.

Die erfindungsgemäße Vorrichtung ist vorzugsweise zur Durchführung des erfindungsgemäßen Verfahrens und/oder einer vorzugsweisen Ausführungsform hiervon ausgebildet. Das erfindungsgemäße Verfahren ist vorzugsweise zur Durchführung mittels der erfindungsgemäßen Vorrichtung und/oder einer vorzugsweisen Ausführungsform hiervon ausgebildet. Gleiches gilt für das erfindungsgemäße Kalibrierverfahren und die erfindungsgemäße Vorrichtung.

Ein beispielhaftes Verfahren zur Bestimmung der Ladungsträgerlebensdauer eines Halbleitersubstrates durch Messung von Lumineszenzstrahlung umfasst folgende Verfahrensschritte:

In einem Verfahrensschritt A erfolgt ein Anregen des Halbleitersubstrates zum Erzeugen von Lumineszenzstrahlung durch Injizieren von Ladungsträgern in dem Halbleitersubstrat, wobei der zeitliche Verlauf der Anregungsintensität $I_A(t)$ periodisch moduliert ist.

In einem Verfahrensschritt B erfolgt ein zeitaufgelöstes Messen der Intensität der von einem Messbereich des Halbleitersubstrates ausgehenden Lumineszenzstrahlung, wobei zumindest der relative zeitliche Verlauf der Lumineszenzstrahlung $\Phi(t)$ zumindest während einer Anregungsperiode gemessen wird.

In einem Verfahrensschritt C erfolgt ein Bestimmen mindestens eines Materialparameters des Halbleitersubstrates abhängig von dem zeitlichen Verlauf der Anregungsintensität $I_A(t)$ und dem zeitlichen Verlauf der Intensität der Lumineszenzstrahlung $\Phi(t)$.

Wesentlich ist, dass in Verfahrensschritt A eine Strom-Spannungsquelle elektrisch leitend mit dem Halbleitersubstrat verbunden wird und mittels der Strom-Spannungsquelle das Anregen mittels Beaufschlagen des Halbleitersubstrates mit zeitlich modulierter elektrischer Spannung erfolgt.

Im Unterschied zu den einleitend genannten Verfahren wird bei dem beispielhaften Verfahren die Lumineszenzstrahlung in dem Halbleitersubstrat somit erzeugt, in dem das Halbleitersubstrat mittels der Strom-Spannungsquelle mit zeitlich modulierter elektrischer Spannung beaufschlagt wird. Bei dem Verfahren wird somit so genannte Elektrolumineszenzstrahlung erzeugt im Gegensatz zu der eingangs genannten Photolumineszenzstrahlung, wobei der Unterschied im Wesentlichen in der Art der Anregung des Halbleitersubstrates liegt.

Das Verfahren vermeidet die zuvor genannten Nachteile:

a) Aufgrund der Erzeugung von Elektrolumineszenzstrahlung mittels Beaufschlagen des Halbleitersubstrates mit seitlich modulierter elektrischer Spannung sind der Positionierung des Detektors zur Detektion der Lumineszenzstrahlung keinerlei Grenzen gesetzt. Der effektive Detektions-Raumwinkel kann somit deutlich größer sein im Vergleich zur Messung von Photolumineszenzstrahlung, so dass kürzere Messzeiten und/oder eine höhere Geräteempfindlichkeit und somit Messgenauigkeit erzielt wird.

b) Da keine Lichtquelle zum Beaufschlagen des Halbleitersubstrates mit elektromagnetischer Strahlung zum Erzeugen von Lumineszenzstrahlung notwendig ist, kann bei dem erfindungsgemäßen Verfahren beispielsweise auch ein Halbleitersubstrat vermessen werden, welches einseitig eine vollflächige Metallisierung aufweist.

c) Strom-Spannungsquellen sind handelsüblich und insbesondere erheblich kostengünstiger als die zuvor genannten Strahlungsquellen zum Erzeugen von Photolumineszenzstrahlung wie beispielsweise Hochleistungslaser.

Bei dem Verfahren wird somit Elektrolumineszenzstrahlung für zeitaufgelöste Bestimmungen von Materialparametern des Halbleitersubstrates, insbesondere zeitaufgelöste Lebensdauermessungen verwendet, in dem die vorgenannte Strahlungsquelle zum Erzeugen der Photolumineszenzstrahlung ersetzt wird durch die Strom-Spannungsquelle zum Erzeugen der Elektrolumineszenzstrahlung, wobei das Halbleitersubstrat mit zeitlicher modulierter elektrischer Spannung beaufschlagt wird.

Die vorliegende Erfindung verbindet somit die aus genannten Gründen vorteilhafte Methodik dynamischer, zeitmodulierter Bestimmungsmethoden von Materialparametern wie der Ladungsträgerlebensdauer in Halbleitersubstraten mit dem Prinzip der elektrischen Ladungsträgerinjektion (Elektrolumineszenz). Dadurch wird sowohl eine technische Verfahrensoptimierung als auch eine erhebliche Kostensenkung der Vorrichtung im Vergleich zum Stand der Technik erzielt.

Untersuchungen des Anmelders haben ergeben, dass vorzugsweise in Verfahrensschritt C eine effektive Lebensdauer des Halbleitersubstrates selbstkonsistent bestimmt wird. Die Methode einer selbstkonsistenten Bestimmung einer effektiven Lebensdauer ist an sich bekannt und beispielsweise in T. Trupke, R.A. Bardos, M.D. Abbott, "Self-Consistent Calibration of Photoluminescence and Photoconductance Lifetime Measurements", Applied Physics Letters, 87: 184102, 2005 sowie in WO 2008/052237 beschrieben und in WO 2011/134602 erweitert (insbesondere Ansprüche 8 bis 10 und zugehörige Beschreibung).

Eine besonders einfache und robuste Bestimmung einer Überschussladungsträgerdichte wird in einer vorzugsweisen Ausführungsform des Verfahrens erzielt, indem in Verfahrensschritt A die Anregung derart periodisch moduliert ist, dass eine Injizierung von Ladungsträgerpaaren in dem Halbleitersubstrat aufgrund der Anregung während einer Anregungsperiode ein Maximum und ein Minimum aufweist und zumindest der relative zeitliche Verlauf der Anregungsintensität $I_A(t)$ gemessen wird und in Verfahrensschritt C eine effektive Lebensdauer $T$ des Halbleitersubstrates zumindest für die während einer Anregungsperiode maximal erreichte Überschussladungsträgerdichte $\Delta n_{max}$ ermittelt wird, in dem die zeitliche Differenz zwischen dem Maximum $I_A(t)$ und einem hierzu korrespondierenden Maximum $\Phi(t)$ bestimmt wird.

Die Methode zur Ermittlung der effektiven Lebensdauer durch Bestimmung der zeitlichen Differenz zwischen den beiden vorgenannten Maxima ist an sich bekannt und in WO 2011/134602 beschrieben. Die Anwendung dieser Methode in der vorbeschriebenen vorteilhaften Ausgestaltung des Verfahrens führt zusätzlich zu den vorgenannten Vorteilen weiterhin zu einem robusten und hinsichtlich des Rechenaufwands einfachen Auswerteverfahren.

Vorzugsweise wird bei dem Verfahren die Anregungsintensität $I_A(t)$ gemessen, in dem der durch das Halbleitersubstrat fließende Strom $I(t)$ zeitabhängig zumindest in relativen Einheiten, vorzugsweise quantitativ gemessen wird. Bei dieser vorzugsweisen Ausführungsform kann somit in einfacher Weise quantitativ die Anregungsintensität $I_A(t)$ oder zumindest ein Maß hierfür zeitabhängig bestimmt werden, denn das zeitabhängige Messen des durch das Halbleitersubstrat fließenden Stroms $I(t)$ ist in einfacher, apparativ unaufwändiger Weise möglich. Insbesondere sind in handelsüblichen Strom-Spannungsquellen typischerweise bereits entsprechende Messeinheiten integriert, so dass die Messsignale für die zeitabhängige Messung des Stroms $I(t)$ in einfacher Weise ausgelesen werden können.

In einer vorzugsweisen Ausführungsform wird der durch das Halbleitersubstrat fließende Strom $I(t)$ gemessen, in dem in dem Stromkreis zwischen Strom-Spannungsquelle und Halbleitersubstrat ein Referenzwiderstand zwischengeschaltet wird und die an dem Referenzwiderstand abfallende Spannung zeitabhängig zumindest in relativen Einheiten, vorzugsweise quantitativ gemessen wird. Hierdurch ergibt sich der Vorteil, dass exakt und apparativ unaufwändig der durch das Halbleitersubstrat fließende Strom zeitabhängig gemessen werden kann.

In einer weiteren vorzugsweisen Ausführungsform wird in Verfahrensschritt C die Auswertung abhängig von einer Generationsrate $G(t)$ durchgeführt, welche Generationsrate die Ladungsträgergeneration in dem Halbleitersubstrat aufgrund des Anregens beschreibt. Insbesondere ist es vorteilhaft, dass die Generationsrate $G(t)$ abhängig von dem gemessenen Strom $I(t)$ bestimmt wird, vorzugsweise gemäß Formel 1

$$G\left(t\right)=\frac{I\left(t\right)}{q\cdot a\cdot d}, \qquad\qquad \text{(Formel 1),}$$

mit der Elementarladung q, der Dicke d, und der Fläche a einer Messseite des Halbleitersubstrates, deren abgestrahlte Lumineszenzstrahlung gemessen wird.

Der Begriff der Generationsrate wird hier in Anlehnung an den Sprachgebrauch bei optisch anregenden Verfahren verwendet. Genauer handelt es sich bei der "Generation" freier Ladungsträger im Falle der Elektrolumineszenz um die Injektion von Minoritätsladungsträgern über den pn-Übergang eines elektrisch kontaktierten Halbleitersubstrates mittels Anlegen einer Spannung in Durchlassrichtung. Die Generationsrate freier Ladungsträger ist damit die volumenbezogene Entsprechung der flächenbezogenen Anregungsintensität $I_A(t)$.

Die erfindungsgemäße Vorrichtung zur Bestimmung der Ladungsträgerlebensdauer eines Halbleitersubstrates durch Messung von Lumineszenzstrahlung vorzugsweise mittels Durchführung eines erfindungsgemäßen Verfahrens bzw. einer vorzugsweise Ausführungsform hiervon weist einen Detektor zum Detektieren der Intensität der von dem Halbleitersubstrat abgestrahlten Lumineszenzstrahlung, eine Anregungseinheit, zum Anregen des Halbleitersubstrates und eine Steuer-Auswerteeinheit auf. Die Steuer-Auswerteeinheit ist derart mit dem Detektor und der Anregungseinheit zusammenwirkend ausgebildet, dass mittels der Steuer-Auswerteeinheit die Beaufschlagung des Halbleitersubstrates vorgebbar und die Messsignale des Detektors auswertbar sind.

Wesentlich ist, dass die Anregungseinheit als modulierbare Strom-Spannungsquelle ausgebildet ist, welche elektrisch mit dem Halbleitersubstrat verbindbar und derart ausgebildet ist, dass abhängig von Steuersignalen der Steuer-Auswerteeinheit das Halbleitersubstrat mit zeitlich modulierter elektrischer Spannung beaufschlagbar ist und dass die Vorrichtung einen Kalibrierstrahler umfasst, welcher an Stelle des Halbleitersubstrates elektrisch leitend mit der Spannungsquelle verbindbar und mit der zeitlich modulierten Spannung der Spannungsquelle derart beaufschlagbar ist, dass eine mittels des mit der zeitliche modulierten Spannung beaufschlagten Kalibrierstrahlers zumindest teilweise auf den Detektor auftreffende Strahlung erzeugt wird,

wobei der Kalibrierstrahler eine elektrische Relaxationszeit kleiner 100 ns aufweist und/oder

dass der Kalibrierstrahler als Halbleiter-Leuchtdiode ausgebildet ist und wobei die Steuer-Auswerteeinheit zur Durchführung einer Kalibrierung derart konfiguriert ist, dass eine Antwortzeit, welche bei Verwendung des Kalibrierstrahlers erhalten wird, als Korrektur der Messwerte bei Messung des Halbleitersubstrates verwendet wird.

Hierdurch ergeben sich die zuvor zu dem erfindungsgemäßen Verfahren aufgeführten Vorteile.

Das erfindungsgemäße Verfahren und die erfindungsgemäße Vorrichtung werden vorteilhafterweise zur Messung zumindest teilweise metallisierter Halbleitersubstrate, insbesondere Siliziumsubstrate und bevorzugt Solarzellen bzw. Vorstufen bei der Herstellung von Solarzellen verwendet. Die Anregungseinheit ist daher vorzugsweise derart ausgebildet, dass die Metallisierung des Halbleitersubstrates elektrisch mit der Anregungseinheit verbindbar ist, derart, dass das Halbleitersubstrat mittels der Anregungseinheit über die metallischen Kontaktierungen mit zeitlich modulierter elektrischer Spannung beaufschlagbar ist.

Untersuchungen des Anmelders haben ergeben, dass zum Erzielen einer hohen Messgenauigkeit vor Durchführen des erfindungsgemäßen Verfahrens bzw. vor Verwendung der erfindungsgemäßen Vorrichtung zum Durchführen des erfindungsgemäßen Verfahrens eine Kalibrierung der erfindungsgemäßen Vorrichtung erfolgt bzw. ein erfindungsgemäßes Kalibrierverfahren durchgeführt wird.

Die erfindungsgemäße Vorrichtung weist daher in einem Kalibriermodus einen Kalibrierstrahler auf, welcher anstelle des Halbleitersubstrates elektrisch leitend mit der Strom-Spannungsquelle verbindbar und derart anordbar ist, dass mittels des Kalibrierstrahlers erzeugte Strahlung zumindest teilweise auf dem Detektor auftrifft.

In dem Kalibriermodus wird somit die von dem Detektor gemessene Strahlung nicht mittels eines zu messenden Halbleitersubstrates sondern mittels des Kalibrierstrahlers erzeugt, welcher Kalibrierstrahler durch die Strom-Spannungsquelle mit elektrischer Energie, insbesondere zeitlich modulierter elektrischer Spannung beaufschlagt wird.

Der Kalibrierstrahler weist in einer ersten Variante eine elektrische Relaxationszeit kleiner 100 ns, vorzugsweise kleiner 30 ns, insbesondere kleiner 10 ns. Hierdurch ist gewährleistet, dass die Unsicherheit einer im erfindungsgemäßen Kalibrierverfahren ermittelten Zeitkorrektur sehr viel kleiner ist als typischerweise aufzulösende Ladungsträger-Lebensdauern.

Zusätzlich oder alternativ ist der Kalibrierstrahler als Halbleiter-Leuchtdiode, insbesondere basierend auf einem direkten Halbleiter ausgebildet. Hierdurch ist eine Relaxationszeit, insbesondere bei Ausbilden des Kalibrierstrahlers als direkter Halbleiter gewährleistet, die für typische Messsituationen geringer als die elektrische Relaxationszeit des zu vermessenden Halbleitersubstrates, insbesondere von typischen Siliziumsubstraten ist.

Die Kalibrierung der erfindungsgemäßen Vorrichtung erfolgt umfassend folgende Verfahrensschritte:

In einem Verfahrensschritt A erfolgt ein Bereitstellen eines Kalibrierstrahlers anstelle des zu vermessenden Halbleitersubstrates, indem der Kalibrierstrahler elektrisch leitend mit der Strom-Spannungsquelle verbunden und derart angeordnet wird, dass von dem Kalibrierstrahler ausgehende elektromagnetische Strahlung zumindest teilweise auf dem Detektor auftrifft.

In einem Verfahrensschritt B erfolgt ein Bestimmen einer Antwortzeit der Vorrichtung, indem der Kalibrierstrahler mittels der Strom-Spannungsquelle zur Erzeugung von Strahlung angeregt wird und die Zeitverzögerung zwischen Anregung des Kalibrierstrahlers und Detektion eines Messsignals des Detektors mittels der Steuer-Auswerteeinheit als Antwortzeit gemessen wird.

Durch dieses Kalibrierverfahren wird somit die Antwortzeit der Messvorrichtung bestimmt, so dass bei Auswerten der Messung des Halbleitersubstrates eine entsprechende Korrektur der Messwerte um die im Kalibrierverfahren bestimmte Antwortzeit erfolgen kann.

Vorzugsweise wird die gemessene Intensität der Lumineszenzstrahlung $\Phi_m(t)$ gemäß Formel 2 korrigiert:

$$\Phi_{EL}\left(t\right) = \Phi_m\left(t + \Delta t_{EL}\right) \qquad \text{(Formel 2),}$$

mit der korrigierten Lumineszenzstrahlungsintensität $\Phi_{EL}(t)$ und der wie zuvor beschrieben bestimmten Antwortzeit $\Delta t_{EL}$.

Untersuchungen des Anmelders haben ergeben, dass typische Messvorrichtungen Antwortzeiten im Bereich 0 bis 30 µs aufweisen. Die Antwortzeiten können somit durchaus in einem relevanten Bereich beispielsweise bei Bestimmung von Ladungsträgerlebensdauern für Siliziumsubstrate liegen, so dass ohne Durchführen solch einer Kalibrierung erhebliche Fehler auftreten können.

Insbesondere die Verwendung einer Nahinfrarot-LED ist vorteilhaft, um mit dem Detektionsspektrum eines typischerweise verwendeten Detektors zu korrespondieren.

Die Kalibrierung erfolgt derart, dass die Antwortzeit als Korrekturwert für mittels der Vorrichtung durchgeführte Messungen verwendet wird, vorzugsweise, indem der zeitliche Verlauf der Intensität der Lumineszenzstrahlung *Φ(t)* um die Antwortszeit korrigiert wird.

Der Kalibrierstrahler ist vorzugsweise als Halbleiter-Leuchtdiode, insbesondere als Leuchtdiode basierend auf einem direkten Halbleiter wie beispielsweise eine AlGaAs-Diode ausgebildet.

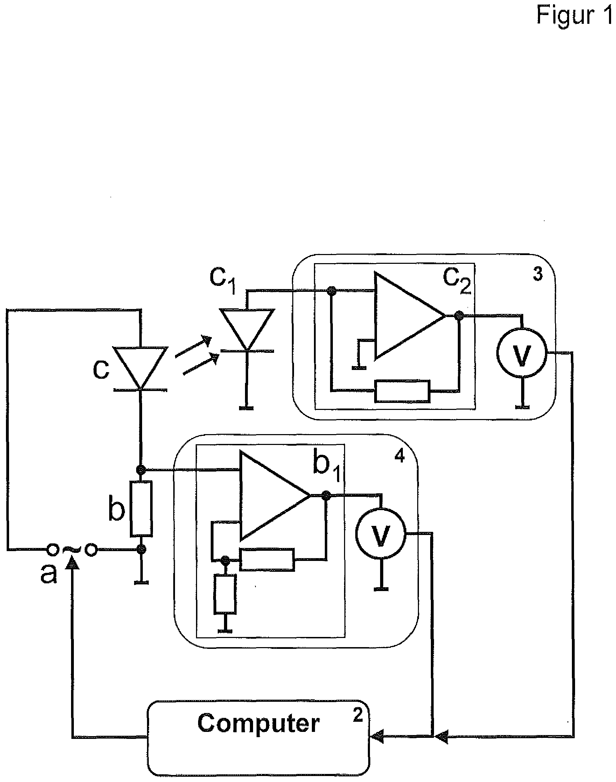

Weitere vorzugsweise Merkmale und Ausführungsformen des erfindungsgemäßen Verfahrens und der erfindungsgemäßen Vorrichtung werden im Folgenden anhand eines Ausführungsbeispiels und Figur 1 beschrieben.

Figur 1 zeigt eine schematische Darstellung eines Ausführungsbeispiels einer erfindungsgemäßen Vorrichtung.

Die Vorrichtung ist in Figur 1 schematisch als elektrischer Schaltkreis dargestellt.

Die Vorrichtung dieses Ausführungsbeispiels umfasst einen Detektor C1, welcher als InGaAs-Detektor ausgebildet ist. Eine Steuer-Auswerteeinheit 2 ist mit einer Messelektronik 3 des Detektors C1 verbunden, um Messsignale des Detektors C1 zeitabhängig aufzunehmen.

Auf einem (nicht dargestellten) Messtisch ist das zu messende Halbleitersubstrat c angeordnet, welches vorliegend eine Siliziumsolarzelle mit metallischen Kontaktierungsstrukturen ist. Die Solarzelle ist elektrisch leitend mit einer Strom-Spannungsquelle a verbunden.

Die Strom-Spannungsquelle a ist mit der Steuer-Auswerteeinheit 2 verbunden, so dass abhängig von Steuersignalen der Steuer-Auswerteeinheit 2 mittels der Strom-Spannungsquelle A das Halbleitersubstrat C mit zeitlich modulierter elektrischer Spannung beaufschlagt wird.

In diesem Ausführungsbeispiel wird die Spannung derart moduliert, dass der durch die Solarzelle fließende Strom einen sinusförmigen Verlauf aufweist.

Zur Bestimmung der Anregungsintensität ist ein Referenzwiderstand B vorgesehen, welcher zwischen Halbleitersubstrat C und Strom-Spannungsquelle a zwischengeschaltet ist.

Die Steuer-Auswerteeinheit 2 ist mit einer Messelektronik 4 verbunden, welche über einen Spannungsverstärker B1 mittels eines Voltmeters V die an dem Referenzwiderstand B abfallende Spannung bestimmt, so dass mittels der Steuer-Auswerteeinheit 2 diese Spannung zeitabhängig aufgenommen werden kann und aufgrund des bekannten Widerstandswertes des Referenzwiderstandes B zeitabhängig der durch das Halbleitersubstrat C fließende Strom mittels der Steuer-Auswerteeinheit bestimmt werden kann.

Die Messelektronik 3 weist einen ähnlichen Aufbau auf, mit einem Spannungsverstärker C2 und einem Voltmeter V, so dass mittels der Steuer-Auswerteeinheit 2 eine Spannung zeitabhängig ausgelesen werden kann. Das Voltmeter kann als eine in einen Steuer- und Auswertecomputer integrierte AD-Wandlerkarte ("ADC: analog digital converter") ausgebildet sein. Die an der AD-Wandlerkarte anliegende Spannung wird digitalisiert und zeitaufgelöst gemessen und beispielsweise mittels eines entsprechenden Computerprogramms ausgewertet.

Abhängig von dem zeitlichen Verlauf der Anregungsintensität, vorliegend bestimmt mittels der am Referenzwiderstand B abfallenden Spannung und dem zeitlichen Verlauf der Intensität der Lumineszenzstrahlung, vorliegend bestimmt mittels Detektor C1 und Messelektronik 3 wird die Minoritätsladungsträgerlebensdauer der Solarzelle mittels der Steuer-Auswerteeinheit 2 bestimmt.

Diese Bestimmung kann in an sich bekannter Weise erfolgen, beispielsweise wie in WO 2011/134602 beschrieben.

Wesentlich ist, dass die Erzeugung der Lumineszenzstrahlung in dem Halbleitersubstrat C durch Beaufschlagen des Halbleitersubstrates C mit zeitlich modulierter elektrischer Spannung (vorliegend zum Erzeugen eines sinusförmigen Stromverlaufs durch das Halbleitersubstrat C) mittels der Strom-Spannungsquelle A erfolgt.

Vor Durchführung des vorgenannten Messverfahrens erfolgt eine Kalibrierung der in Figur 1 dargestellten Vorrichtung:
Hierzu wird das Halbleitersubstrat C ersetzt durch einen Kalibrierstrahler, welcher als AlGaAs-LED ausgebildet ist. Der Kalibrierstrahler wird analog zu dem Halbleitersubstrat C elektrisch leitend mit der Strom-Spannungsquelle A verbunden.

In einem Kalibrierdurchlauf beaufschlagt die Steuer-Auswerteeinheit 2 mittels der Strom-Spannungsquelle A den Kalibrierstrahler mit elektrischer Spannung und misst die Zeit zwischen Beaufschlagung und Eingehen eines Messsignals des Detektors C1. Diese Antwortzeit wird bei der nachfolgenden, zuvor beschriebenen Messung zur Korrektur des zeitlichen Verlaufs der mittels des Detektors C1 gemessenen Lumineszenzstrahlung $\Phi_m(t)$ gemäß folgender Formel 2:

$$\Phi_{EL}(t) = \Phi_m(t + \Delta t_{EL}) \qquad \text{(Formel 2)},$$

bestimmt. Hierbei bezeichnet $\Phi_{EL}(t)$ die korrigierte Lumineszenzstrahlung und $\Delta t_{EL}$ die zuvor beschrieben bestimmte Antwortzeit.

**Patentansprüche**

1. Vorrichtung zur Bestimmung der Ladungsträgerlebensdauer eines Halbleitersubstrates durch Messung von Elektrolumineszenzstrahlung, aufweisend

   einen Detektor (C1) zum Detektieren der Intensität der von dem Halbleitersubstrat (c) abgestrahlten Elektrolumineszenzstrahlung,

   eine Anregungseinheit, zum Anregen des Halbleitersubstrates, ausgebildet als modulierbare Spannungsquelle (a), welche elektrisch mit dem Halbleitersubstrat (c) verbindbar ist,

   und eine Steuer-Auswerteeinheit (2), die derart mit dem Detektor und der Anregungseinheit zusammenwirkend ausgebildet ist, dass mittels der Steuer-Auswerteeinheit (2) die Beaufschlagung des Halbleitersubstrates mit zeitlich modulierter Spannung vorgebbar und die Messsignale des Detektors auswertbar sind,

   wobei die Anregungseinheit derart ausgebildet ist, dass abhängig von Steuersignalen der Steuer-Auswerteeinheit (2) das Halbleitersubstrat (c) mit zeitlich modulierter elektrischer Spannung beaufschlagbar ist und dass die Vorrichtung einen Kalibrierstrahler umfasst, welcher an Stelle des Halbleitersubstrates elektrisch leitend mit der Spannungsquelle (a) verbindbar und mit der zeitlich modulierten Spannung der Spannungsquelle (a) derart beaufschlagbar ist, dass eine mittels des mit der zeitliche modulierten Spannung beaufschlagten Kalibrierstrahlers zumindest teilweise auf den Detektor (C1) auftreffende Strahlung erzeugt wird,

   wobei der Kalibrierstrahler eine elektrische Relaxationszeit kleiner 100 ns aufweist und/oder

   wobei der Kalibrierstrahler als Halbleiter-Leuchtdiode ausgebildet ist und

   wobei die Steuer-Auswerteeinheit (2) zur Durchführung einer Kalibrierung derart konfiguriert ist, dass eine Antwortzeit, welche bei Verwendung des Kalibrierstrahlers mittels der Vorrichtung bestimmt wird,

   als Korrektur der mittels der Vorrichtung gemessenen Messwerte bei Messung des Halbleitersubstrates verwendet wird.

2. Kalibrierverfahren zur Kalibrierung einer Vorrichtung zur Bestimmung der Ladungsträgerlebensdauer eines Halbleitersubstrates durch Messung von Elektrolumineszenzstrahlung,

   folgende Verfahrensschritte umfassend:

   a0.Bereitstellen einer Vorrichtung zur Bestimmung der Ladungsträgerlebensdauer eines Halbleitersubstrates durch Messung von Elektrolumineszenzstrahlung, aufweisend

   einen Detektor (C1) zum Detektieren der Intensität der von dem Halbleitersubstrat (c) abgestrahlten Elektrolumineszenzstrahlung,

   eine Anregungseinheit, zum Anregen des Halbleitersubstrates, ausgebildet als modulierbare Spannungsquelle (a), welche elektrisch mit dem Halbleitersubstrat (c) verbindbar ist,

   und eine Steuer-Auswerteeinheit (2), die derart mit dem Detektor und der Anregungseinheit zusammenwirkend ausgebildet ist, dass mittels der Steuer-Auswerteeinheit (2) die Beaufschlagung des Halbleitersubstrates mit zeitlich modulierter Spannung vorgebbar und die Messsignale des Detektors auswertbar sind,

   wobei die Anregungseinheit derart ausgebildet ist, dass abhängig von Steuersignalen der Steuer-Auswerteeinheit (2) das Halbleitersubstrat (c) mit zeitlich modulierter elektrischer Spannung beaufschlagbar ist,

   a. Bereitstellen eines Kalibrierstrahlers anstelle des zu vermessenden Halbleitersubstrates, indem der Kalibrierstrahler elektrisch leitend mit der Spannungsquelle (a) verbunden und derart angeordnet wird, dass von dem Kalibrierstrahler ausgehende elektromagnetische Strahlung zumindest teilweise auf den Detektor (C1) auftrifft;

   b. Bestimmen einer Antwortzeit der Vorrichtung, indem der Kalibrierstrahler mittels der Spannungsquelle (a) zur Erzeugung von Strahlung angeregt wird und die Zeitverzögerung zwischen Anregung des Kalibrierstrahlers und Detektion eines Messsignals des Detektors mittels der Steuer-Auswerteeinheit (2) als Antwortzeit gemessen wird;

   c. Durchführen einer Kalibrierung derart, dass die Antwortzeit als Korrekturwert für mittels der Vorrichtung durchgeführte Messungen verwendet wird.

3. Kalibrierverfahren nach Anspruch 2,
   **dadurch gekennzeichnet,**
   **dass** die Kalibrierung derart erfolgt, dass die Antwortzeit als Korrekturwert für mittels der Vorrichtung durchgeführte Messungen verwendet wird, indem der zeitliche Verlauf der Intensität der Elektrolumineszenzstrahlung $\Phi(t)$ um die Antwortzeit korrigiert wird.

4. Kalibrierverfahren nach einem der Ansprüche 2 bis 3,
   **dadurch gekennzeichnet,**

**dass** als Kalibrierstrahler ein Strahler mit einer gegenüber dem zu vermessenden Halbleitersubstrat (c) geringer elektrische Relaxationszeit, insbesondere eine elektrische Relaxationszeit kleiner 100 ns, vorzugsweise kleiner 30 ns, insbesondere kleiner 10 ns verwendet wird.

5. Kalibrierverfahren nach einem der Ansprüche 2 bis 4,
**dadurch gekennzeichnet,**
**dass** als Kalibrierstrahler eine Halbeiter-Leuchtdiode, insbesondere eine Leuchtdiode basierend auf einem direkten Halbeiter, verwendet wird.

6. Kalibrierverfahren nach einem der Ansprüche 2 bis 5,
**dadurch gekennzeichnet,**
**dass** das Kalibrierverfahren vor Durchführen eines Verfahren zur Bestimmung von Materialparametern insbesondere der Ladungsträgerlebensdauer eines Halbleitersubstrates durch Messung von Elektrolumineszenzstrahlung durchgeführt wird, folgende Verfahrensschritte umfassend:

a. Anregen des Halbleitersubstrats zum Erzeugen von Elektrolumineszenzstrahlung durch injizieren von Ladungsträgern in dem Halbleitersubstrat (c), wobei der zeitliche Verlauf der Anregungsintensität $I_A(t)$ periodisch zeitmoduliert ist;
b. Zeitaufgelöstes Messen der Intensität der von einem Messbereich des Halbleitersubstrates ausgehenden Elektrolumineszenzstrahlung, wobei zumindest der relative zeitliche Verlauf der Elektrolumineszenzstrahlung $\Phi(t)$ zumindest während einer Anregungsperiode gemessen wird;
c. Bestimmen mindestens eines Materialparameters des Halbleitersubstrates abhängig von dem zeitlichen Verlauf der Anregungsintensität $I_A(t)$ und dem zeitlichen Verlauf der Intensität der Elektrolumineszenzstrahlung $\Phi(t);$

wobei in Verfahrensschritt A eine Spannungsquelle (a) elektrisch leitend mit dem Halbleitersubstrat (c) verbunden wird und mittels der Spannungsquelle (a) das Anregen mittels Beaufschlagen des Halbleitersubstrates mit zeitlich modulierter elektrischer Spannung erfolgt.

**Claims**

1. Device for determining the charge carrier lifetime of a semiconductor substrate by measurement of electroluminescent radiation, having
a detector (C1) for detecting the intensity of the electroluminescent radiation emitted by the semiconductor substrate (c),
an excitation unit, for exciting the semiconductor substrate, in the form of a modulatable voltage source (a) which is electrically connectible to the semiconductor substrate (c),
and a control/analysis unit (2) which is designed to co-operate with the detector and the excitation unit in such a way that by means of the control/analysis unit (2) the application of time-modulated voltage to the semiconductor substrate is specifiable and the measurement signals of the detector are analysable,
wherein the excitation unit is configured in such a way that time-modulated electrical voltage can be applied to the semiconductor substrate (c) in dependence upon control signals of the control/analysis unit (2), and the device comprises a calibration radiator which is electrically conductively connectible to the voltage source (a) instead of the semiconductor substrate and to which the time-modulated voltage of the voltage source (a) can be applied in such a way that by means of the calibration radiator to which the time-modulated voltage is applied a radiation is generated that is at least partly incident on the detector (C1), wherein the calibration radiator has an electric relaxation time of less than 100 ns and/or
wherein the calibration radiator is in the form of a semiconductor light-emitting diode and
wherein the control/analysis unit (2) is configured for performing a calibration in such a way that a response time, which is determined by means of the device when the calibration radiator is used, is used as correction for the measured values measured by means of the device during measurement of the semiconductor substrate.

2. Calibration method for calibrating a device for determining the charge carrier lifetime of a semiconductor substrate by measurement of electroluminescent radiation,
comprising the following method steps:

a0. provision of a device for determining the charge carrier lifetime of a

semiconductor substrate by measurement of electroluminescent radiation, having

a detector (C1) for detecting the intensity of the electroluminescent radiation emitted by the semiconductor substrate (c),

an excitation unit, for exciting the semiconductor substrate, in the form of a modulatable voltage source (a) which is electrically connectible to the semiconductor substrate (c),

and a control/analysis unit (2) which is designed to co-operate with the detector and the excitation unit in such a way that by means of the control/analysis unit (2) the application of time-modulated voltage to the semiconductor substrate is specifiable and the measurement signals of the detector are analysable,

wherein the excitation unit is configured in such a way that time-modulated electrical voltage can be applied to the semiconductor substrate (c) in dependence upon control signals of the control/analysis unit (2),

a. provision of a calibration radiator instead of the semiconductor substrate to be measured, by the calibration radiator being electrically conductively connected to the voltage source (a) and arranged in such a way that electromagnetic radiation emitted by the calibration radiator is at least partly incident on the detector (C1);

b. determination of a response time of the device, by the calibration radiator being excited by means of the voltage source (a) to generate radiation and the time-delay between excitation of the calibration radiator and detection of a measurement signal of the detector being measured as response time by means of the control/analysis unit (2);

c. performance of a calibration in such a way that the response time is used as correction value for measurements carried out by means of the device.

3. Calibration method according to claim 2,
   **characterised in that**
   the calibration takes place in such a way that the response time is used as correction value for measurements carried out by means of the device, the course of the intensity of the electroluminescent radiation over time $\Phi(t)$ being corrected by the response time.

4. Calibration method according to either one of claims 2 and 3,
   **characterised in that**
   as calibration radiator there is used a radiator having an electric relaxation time shorter than the semiconductor substrate (c) to be measured, especially an electric relaxation time of less than 100 ns, preferably less than 30 ns, especially less than 10 ns.

5. Calibration method according to any one of claims 2 to 4,
   **characterised in that**
   as calibration radiator there is used a semiconductor light-emitting diode, especially a light-emitting diode based on a direct semi-conductor.

6. Calibration method according to any one of claims 2 to 5,
   **characterised in that**
   the calibration method is carried out before a method for determining material parameters, especially the charge carrier lifetime, of a semi-conductor substrate is performed by measurement of electroluminescent radiation, comprising the following method steps:

   a. excitation of the semiconductor substrate to generate electroluminescent radiation by injection of charge carriers in the semiconductor substrate (c), the course of the excitation intensity over time $I_A(t)$ being periodically time-modulated;

   b. time-resolved measurement of the intensity of the electroluminescent radiation emitted by a measurement region of the semiconductor substrate, at least the relative course of the electroluminescent radiation over time $\Phi(t)$ being measured at least during an excitation period;

   c. determination of a material parameter of the semiconductor substrate in dependence upon the course of the excitation intensity over time $I_A(t)$ and the course of the intensity of the electroluminescent radiation over time $\Phi(t)$;

   wherein, in method step A, a voltage source (a) is electrically conductively connected to the semiconductor substrate (c) and by means of the voltage source (a) the excitation is effected by means of application of time-modulated electrical voltage to the semi-conductor substrate.

**EP 2 976 651 B1**

**Revendications**

1. Dispositif de détermination de la durée de vie des porteurs de charge d'un substrat en semiconducteur par mesure du rayonnement d'électroluminescence, comprenant un détecteur (C1) destiné à détecter l'intensité du rayonnement d'électroluminescence émis par le substrat en semiconducteur (c),
une unité d'excitation destinée à exciter le substrat en semiconducteur, réalisée sous la forme d'une source de tension (a) modulable qui peut être reliée électriquement au substrat en semiconducteur (c),
une unité de commande et d'interprétation (2), qui est configurée de manière à coopérer avec le détecteur et l'unité d'excitation de telle sorte que l'unité de commande et d'interprétation (2) permet de prédéfinir la charge du substrat en semiconducteur avec une tension modulée dans le temps et d'interpréter les signaux de mesure du détecteur, l'unité d'excitation étant configurée de telle sorte que le substrat en semiconducteur (c) peut être chargé avec une tension électrique modulée dans le temps en fonction de signaux de commande de l'unité de commande et d'interprétation (2), et le dispositif comportant une source de rayonnement d'étalonnage qui peut être reliée électriquement à la source de tension (a) à la place du substrat en semiconducteur et qui peut être chargée avec la tension modulée dans le temps de la source de tension (a) de telle sorte qu'un rayonnement qui vient au moins partiellement frapper le détecteur (C1) est généré au moyen de la source de rayonnement d'étalonnage chargée avec la tension modulée dans le temps,
la source de rayonnement d'étalonnage possédant un temps de relâchement électrique inférieur à 100 ns et/ou l'unité de commande et d'interprétation (2) étant configurée pour réaliser un étalonnage de telle sorte qu'un temps de réaction, qui est déterminé au moyen du dispositif lors de l'utilisation de la source de rayonnement d'étalonnage, est utilisé comme correction des valeurs mesurées au moyen du dispositif lors de la mesure du substrat en semiconducteur.

2. Procédé d'étalonnage pour étalonner un dispositif de détermination de la durée de vie des porteurs de charge d'un substrat en semiconducteur par mesure du rayonnement d'électroluminescence, comprenant les étapes suivantes :

   a0 fourniture d'un dispositif de détermination de la durée de vie des porteurs de charge d'un substrat en semiconducteur par mesure du rayonnement d'électroluminescence, comprenant
   un détecteur (C1) destiné à détecter l'intensité du rayonnement d'électroluminescence émis par le substrat en semiconducteur (c),
   une unité d'excitation destinée à exciter le substrat en semiconducteur, réalisée sous la forme d'une source de tension (a) modulable qui peut être reliée électriquement au substrat en semiconducteur (c),
   une unité de commande et d'interprétation (2), qui est configurée de manière à coopérer avec le détecteur et l'unité d'excitation de telle sorte que l'unité de commande et d'interprétation (2) permet de prédéfinir la charge du substrat en semiconducteur avec une tension modulée dans le temps et d'interpréter les signaux de mesure du détecteur,
   l'unité d'excitation étant configurée de telle sorte que le substrat en semiconducteur (c) peut être chargé avec une tension électrique modulée dans le temps en fonction de signaux de commande de l'unité de commande et d'interprétation (2),
   a. fourniture d'une source de rayonnement d'étalonnage à la place du substrat en semiconducteur à mesurer, en reliant électriquement la source de rayonnement d'étalonnage à la source de tension (a) et en la disposant de telle sorte que le rayonnement émis par la source de rayonnement d'étalonnage vient au moins partiellement frapper le détecteur (C1) ;
   b. détermination d'un temps de réponse du dispositif en excitant la source de rayonnement d'étalonnage au moyen de la source de tension (a) en vue de générer un rayonnement et en mesurant, comme temps de réponse, le retard dans le temps entre l'excitation de la source de rayonnement d'étalonnage et la détection d'un signal de mesure du détecteur au moyen de l'unité de commande et d'interprétation (2) ;
   c. réalisation d'un étalonnage de telle sorte que le temps de réaction est utilisé comme valeur de correction pour les mesures effectuées au moyen du dispositif.

3. Procédé d'étalonnage selon la revendication 2, **caractérisé en ce que** l'étalonnage est effectué de telle sorte que le temps de réponse est utilisé comme valeur de correction pour les mesures effectuées au moyen du dispositif par correction de l'évolution dans le temps de l'intensité du rayonnement d'électroluminescence $\Phi(t)$ par le temps de réponse.

4. Procédé d'étalonnage selon l'une des revendications 2 à 3, **caractérisé en ce que** la source de rayonnement d'étalonnage utilisée est une source de rayonnement ayant un temps de relâchement électrique inférieur à celui du substrat en semiconducteur (c) à mesurer, notamment un temps de relâchement électrique inférieur à 100 ns, de préférence inférieur à 30 ns, en particulier inférieur à 10 ns.

**5.** Procédé d'étalonnage selon l'une des revendications 2 à 4, **caractérisé en ce que** la source de rayonnement d'étalonnage utilisée est une diode électroluminescente en semiconducteur, notamment une diode électroluminescente basée sur un semiconducteur direct.

**6.** Procédé d'étalonnage selon l'une des revendications 2 à 5, **caractérisé en ce que** le procédé d'étalonnage est mis en œuvre avant la mise en œuvre d'un procédé de détermination de paramètres matériels, notamment de la durée de vie des porteurs de charge d'un substrat en semiconducteur par mesure du rayonnement d'électroluminescence, comprenant les étapes suivantes :

a. excitation du substrat en semiconducteur en vue de générer un rayonnement d'électroluminescence par injection de porteurs de charge dans le substrat en semiconducteur (c), l'évolution dans le temps de l'intensité d'excitation $I_A(t)$ étant modulée périodiquement dans le temps ;
b. mesure déclenchée dans le temps de l'intensité du rayonnement d'électroluminescence émanant d'une zone de mesure du substrat en semiconducteur, au moins l'évolution dans le temps relative de l'intensité du rayonnement d'électroluminescence $\Phi(t)$ étant mesurée au moins pendant une période d'excitation ;
c. détermination d'au moins un paramètre matériel du substrat en semiconducteur en fonction de l'évolution dans le temps de l'intensité d'excitation $I_A(t)$ et de l'évolution dans le temps de l'intensité du rayonnement d'électroluminescence $\Phi(t)$ ;

dans l'étape A du procédé, une source de tension (a) étant reliée électriquement au substrat en semiconducteur (c) et l'excitation s'effectuant au moyen de la source de tension (a) en chargeant le substrat en semiconducteur avec une tension électrique modulée dans le temps.

Figur 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2011134602 A
- CN 102608510
- EP 2568275 A2
- WO 2008052237 A

**In der Beschreibung aufgeführte Nicht-Patentliteratur**

- **FUYUKI, T. et al.** Photographic surveying of minority carrier diffusion length in polycrystalline silicon solar cells by electroluminescence. *Applied Physics Letters,* 2005, vol. 86, 262108
- **WÜRFEL, P. et al.** Diffusions lengths of silicon solar cells from luminescence images. *Journal of Applied Physics,* 2007, vol. 101, 123110
- **TRUPKE, T. et al.** Photoluminescence imaging of silicon wafers. *Applied Physics Letters,* 2006, vol. 89, 044107
- **T. TRUPKE ; R. A. BARDOS.** *31 st IEEE PVSC,* 2005
- **T. TRUPKE ; R.A. BARDOS ; M.D. ABBOTT.** Self-Consistent Calibration of Photoluminescence and Photoconductance Lifetime Measurements. *Applied Physics Letters,* 2005, vol. 87, 184102
- **J.A. GIESECKE ; M.C. SCHUBERT ; W. WARTA.** Self-sufficient minority carrier lifetime in silicon from quasi-steady-state photoluminescence. *Phys. Stat. Sol. A,* 2012, vol. 209, 2286